# EUROPEAN PATENT APPLICATION

(11) **EP 4 228 010 A1**
(43) Date of publication of application: **16.08.2023**
(21) Application number: 21913850.0
(22) Date of filing: 10.12.2021
(51) Int. Cl.: H01L 31/05, H01L 31/18

(54) **PACKAGING METHOD FOR SOLAR CELL MODULE, CONNECTION METHOD FOR SOLAR CELL STRING, SOLAR CELL MODULE, AND PREPARATION METHOD THEREFOR**

(30) Priority: 30.12.2020 CN 202011613801; 03.11.2021 CN 202111295282; 03.11.2021 CN 202111294050; 03.11.2021 CN 202111295283
(71) Applicant: Risen Energy Co. Ltd, Ningbo Zhejiang 315600 (CN)
(72) Inventor: HUANG, Qiang, Ningbo, Zhejiang 315600 (CN); CAI, Houmin, Ningbo, Zhejiang 315600 (CN); CUI, Yanfeng, Ningbo, Zhejiang 315600 (CN)
(74) Representative: Baldus, Oliver
(86) International application number: PCT/CN2021/137197
(87) International publication number: WO 2022/143109

(57) **Abstract**

A packaging method for a solar cell module and a solar cell module, comprising: a battery piece (1) acquisition step: acquiring battery pieces (1) that are printed with fine gate lines (3) and do not have a main gate or that only comprise a fine main gate; a battery piece (1) connecting step: connecting any two battery pieces (1) by means of a welding strip (2) so as to form a plurality of battery strings, wherein connecting any two battery pieces (1) by means of a welding strip (2) comprises fixing the welding strip (2) on the battery pieces (1) by means of a colloid (4), the welding strip (2) is enabled to make direct contact with the fine gate lines (3) on the corresponding battery pieces (1), and each battery string comprises a plurality of battery pieces (1); a battery string packaging step: typesetting the plurality of battery strings, and welding bus bars so as to form a battery string laminate; and a battery string laminate packaging step: heating and laminating the battery string laminate, such that each welding strip (2) respectively forms an alloy connection with the fine gate lines (3) on the surface of the corresponding battery pieces (1), so as to complete the packaging of a solar cell module.

## Description

### Cross-reference to Related Application

The present disclosure claims the priority to the Chinese patent application filed with the Chinese Patent Office on December 30, 2020 with the filing No. 202011613801.7, and entitled "Packaging Method of Solar Cell Module and Solar Cell Module", the Chinese patent application filed with the Chinese Patent Office on November 3, 2021 with the filing No. 202111295282.9, and entitled "Connection Method of Solar Cell String, Solar Cell Module, and Preparation Process of Solar Cell Module", the Chinese patent application filed with the Chinese Patent Office on November 3, 2021 with the filing No. 202111294050.1, and entitled "Connecting Method of Solar Cell String and Manufacturing Method of Solar Cell Module", and the Chinese patent application filed with the Chinese Patent Office on November 3, 2021 with the filing No. 202111295283.3, and entitled "Connection Method of Solar Cell String, Solar Cell Module, and Preparation Method of Solar Cell Module", all the contents of which are incorporated herein by reference in entirety.

### Technical Field

The present disclosure relates to a solar cell module and a preparation method thereof, a packaging method for a solar cell module, and a connection method for a solar cell string..

### Background Art

In the photovoltaic manufacturing field, a manufacturing process of a solar cell module includes firstly printing a fine grid line and a main grid line on a surface of a cell, then connecting a plurality of cells through a welding strip into a cell string, and finally obtaining a cell module after performing processes such as typesetting and laminating on the cell strings. The solar cell module realizes collection of currents of the cells through the welding strip, the main grid line, and the fine grid line on the surfaces of the cells, and further realizes the function of the cell module, wherein the main grid line and the fine grid line are both made of silver paste.

The heterojunction cell is a good choice in the field of photovoltaic power generation due to its excellent performances such as high efficiency, low attenuation rate, simple process, and good structural ductility, but as a large amount of silver paste is used in the heterojunction cell, the cost remains high, which limits large-scale development thereof.

In order to reduce the cost of heterojunction cell module, the number of main grid lines on the surface of the cell is usually increased. However, this method is generally only directed to a cell having 5 to 9 main grid lines, for example, the consumption of silver paste for a cell with 9 main grid lines is generally 200 mg/cell, while the consumption of silver paste for a cell with 5 main grid lines is 400 mg/cell.

However, when the number of main grid lines on the cell is increased to a certain number, the method of increasing the number of main grid lines not only fails to reduce the consumption of silver paste for the cell, but rather increases the amount of silver paste of the cell, thereby increasing the cost of the solar cell module.

In addition, with regard to the problem of reducing the amount of silver paste for the cell, there are a plurality of technologies in the relevant art, for example, patent document US8013239B2 from Meyer Burger, Switzerland discloses an intelligent wire, which realizes packaging of a solar cell module with a huge amount of main grid lines (the number of main grid lines is at least 18) by a manner of combining a polymeric film with a conductive transmission copper strip. The cell in this patent does not require a main grid line, and the main grid lines on a front surface and a back surface of the cell are directly replaced by the intelligent wire, which is electrically connected to fine grid lines on the surface of the cell, which can reduced the consumption of silver paste for the heterojunction battery to 60 mg/cell, greatly reducing the consumption of silver paste for the cell compared with the manner of increasing the number of main grid lines. However, in the intelligent wire in this patent, a polymeric film layer needs to be coated on the surface of the conductive transmission copper strip, so that a manufacturing process of coating the copper strip is added, and the manufacturing cost is increased; furthermore, the polymeric film is required in material, which increases the material cost, therefore, the intelligent wire only reduces the consumption of silver paste, but increases the overall cost of the cell module.

For another example, patent document CN106847968A discloses a packaging method of a double-faced crystalline silicon heterojunction main-grid-free solar cell, wherein copper wires having a diameter ranging from 10 to 80 µm and plated with a metal anti-oxidation layer are laid on HIT main-grid-free cell, wherein when heights of fine grid lines are greater than the diameter of the copper wires, contact points of the copper wires and the grid lines are junctions, and colloids are cured after heat-pressure-sensitive adhesive or photosensitive adhesive covers the copper wires and the cell in a copper wire direction; and when the heights of the fine grid lines are smaller than the diameter of the copper wires, a round pattern curing conductive paste is dotted or a conductive adhesive tape is adhered at the junctions of the copper wires and grid lines, the copper wires are laid, and hot-pressing fixation is performed at the temperature of 200 °C or below; finally, the copper wires and the cell are hot-pressed to complete packaging of the double-faced main-grid-free HIT solar cell. This packaging method is applied to the packaging of the cell by replacing the original main grid lines on the cell with the copper wires coated with the metal anti-oxidation layer, and can greatly reduce the consumption of silver paste and the production cost; however, in this packaging method, when the heights of the fine grid lines are greater than the diameter of the copper wires, the heat-pressure-sensitive adhesive or the photosensitive adhesive needs to cover the copper wires and the cell along the direction of the copper wires, and there is a large amount of adhesive in this process, moreover, such a manner of first applying the adhesive and then welding easily causes flow of the adhesive to enter contact points between the copper wires and the fine grid lines, affecting the contact between the copper wires and the fine grid lines, thereby affecting the conductive soldering and conductivity, and causing problems such as electrical failure; In addition, as the packaging method uses different fixing manners according to different heights of the fine grid lines, it is also necessary to judge the heights of the fine grid lines and the heights of the copper wires during the manufacturing process, which is relatively difficult to operate during the manufacturing process.

For another example, patent document CN105762202A discloses a solar battery front electrode with combination of points and lines and a preparation method therefor, which reduces the consumption of sliver paste by printing silver paste points on a cell, then replacing part of silver paste grid lines with copper wires, and combining the copper wires with the silver paste points. This solar battery front electrode with combination of points and lines, realizing the grid line on the cell by replacing silver with copper of a relatively low cost, only aims at improving the replacement of material consumption of the main grid lines and the fine grid lines on the solar cell itself, wherein not only the electrical conductivity of the solar cell is reduced, but also the requirement for mechanical connection of a plurality of cells in a subsequent cell module cannot be satisfied, as the copper wires are thin copper wires having a diameter of 0.01 mm to 0.08 mm.

Therefore, based on the above related art, for the heterojunction cell module, the manufacturing cost thereof is increased, or the connection performance of the cell module is also reduced while reducing the cost. That is, the related art cannot reduce the manufacturing cost of the heterojunction cell module while ensuring good performances of the heterojunction cell module in various aspects, which is not conducive to mass production of the heterojunction cell module.

In addition, when main-grid-free cells are connected in series to be made into a cell string, first adhesive is dispensed on the cells, and then the welding strips are connected to the cells through the adhesive. However, the inventors of the present disclosure found that such an operation manner easily causes poor conduction between the welding strips and the fine grid lines. Besides, when connecting the cells in series, if first the adhesive is dispensed on a back surface of each cell or a lower surface of each welding strip, and then the welding strip is connected to the cell by the adhesive, the adhesive on the back surface of the cell and the adhesive on the lower surface of the welding strip will both be easy to drip, thus causing unstable connection between the welding strip and the cell.

Furthermore, the inventors of the present disclosure found in research that different influences are caused when the adhesive is dispensed on the welding strip or the cell, and the order of dispensing the adhesive and arranging the welding strip also has different influences. The inventors of the present disclosure tried to dispense the adhesive on the welding strip, and then connect the cell with the welding strip through an adhesive, however, the inventors found that when the adhesive is dispensed in this manner, due to existence of grid lines on the cell, when the cell is connected to the adhesive on the welding strip, the adhesive is likely to stick to a non-preset position on the cell.

In order to improve the above situation, the inventors of the present disclosure tried to first dispense the adhesive on both front surfaces and back surfaces of a plurality of cells, and then bond the welding strips to the adhesive on the surfaces of the cells to obtain the cell string. However, the inventors found that, when the adhesive is dispensed in such a manner, it is not easy to be achieved in operations, because when dispensing the adhesive on the front and back surfaces of the cell, the cell needs to be fixed. If the cell is fixed in the air by a suction cup, no matter whether the suction cup adsorbs the front surface or the back surface of the cell, it is inconvenient to perform the adhesive dispensing operation on the adsorbed surface. Although it is possible to first absorb the front surface and dispense the adhesive on the back surface, and then absorb the back surface and dispense the adhesive on the front surface, such operations are very troublesome. If the cell is placed on a bearing surface to dispense the adhesive, it is inconvenient for the surface in contact with the bearing surface to dispense the adhesive.

### Summary

In order to overcome the shortcomings of in the related art, the present disclosure aims at providing a packaging method for a solar cell module, a connection method for a solar cell string, a solar cell module, and a preparation method therefor, which can reduce the consumption of silver paste and save the manufacturing cost without increasing the manufacturing process steps and the cost of other materials.

In a first aspect, the present disclosure provides a packaging method for a solar cell module, including: a step of acquiring cells (battery pieces), acquiring cells printed with fine grid lines and without a main grid line or only containing fine main grid lines; a step of connecting the cells, connecting any two cells through welding strips so as to obtain a plurality of cell strings (battery strings), wherein the step of connecting any two cells through the welding strips specifically includes fixing the welding strips on the cells through colloids, and making the welding strips in direct contact with the fine grid lines on corresponding cells; and each cell string includes a plurality of cells; a step of packaging the cell strings, performing a typesetting and welding bus bars on the plurality of cell strings so as to obtain a cell string laminate; and a step of packaging the cell string laminate, heating and laminating the cell string laminate, so that each welding strip forms an alloy connection with the fine grid lines on a surface of corresponding cell, so as to complete the packaging of the solar cell module.

In a second aspect, the present disclosure provides a solar cell module, wherein the solar cell module is manufactured by the above packaging method for a solar cell module.

In a third aspect, the present disclosure further provides a solar cell module, including a plurality of cell strings, and each cell string including: a plurality of cells, each printed with fine grid lines and without a main grid; and a plurality of welding strips, connecting two adjacent cells to form a cell string, the welding strips being fixed on a corresponding cell through colloids, and the welding strips being in direct contact with the fine grid lines on the corresponding cell, wherein the plurality of cell strings form the cell string laminate by typesetting and welding bus bars, and each welding strip forms an alloy connection with the fine grid lines on a surface of corresponding cell through heating and laminating.

In a fourth aspect, the present disclosure provides a connection method for a solar cell string, including: S31: providing a cell; S32: arranging welding strips on a front surface and a back surface of the cell; S33: applying adhesive to designated positions on the front surface and the back surface of the cell, and connecting the cell and the welding strips by applying the adhesive; and S44: repeating step S31 to step S33 to complete connection of a preset number of cells, so as to obtain the solar cell string.

In a fifth aspect, the present disclosure provides a connection method for a solar cell string, wherein the cell string includes a plurality of cells connected in series, two adjacent ones of the cells are connected through welding strips, each of the welding strips includes a first segment and a second segment, and the connection method includes: S41: arranging a first welding strip, and applying adhesive to an upper surface of the first segment of the first welding strip to form colloids; S42: arranging a cell on the first segment of the first welding strip, so that a back surface of the cell is connected to the first segment of the first welding strip; S43: applying the adhesive to preset positions on a front surface of the cell to form the colloids; S44: arranging the second segment of a second welding strip on the front surface of the cell, so that the second segment of the second welding strip is connected to the front surface of the cell; and S45: repeating steps S41-S44 to complete connection of a preset number of cells, forming the cell string.

In a sixth aspect, the present disclosure provides a connection method for a solar cell string, wherein the cell string includes a plurality of cells connected in series, two adjacent ones of the cells are connected together through welding strips, each of the welding strips includes a first segment and a second segment, and the connection method includes: S51: providing a cell, and applying adhesive to designated positions on a back surface of the cell; S52: arranging the cell on the first segment of an arranged first welding strip, so that the back surface of the cell is connected with the first segment of the first welding strip; S53: applying the adhesive to designated positions on a front surface of the cell; S54: arranging the second segment of a second welding strip on the front surface of the cell, so that the second segment of the second welding strip is connected to the front surface of the cell; and S55: repeating steps S51-S54 to complete connection of a preset number of cells, so as to obtain the cell string.

In a seventh aspect, the present disclosure provides a manufacturing method for a solar cell module, including the above connection method for a solar cell string, and a step of heating and laminating the formed cell strings.

In an eighth aspect, the present disclosure provides a solar cell module, manufactured by the above manufacturing method for a solar cell module.

### Brief Description of Drawings

In order to more clearly illustrate the technical solutions of the present disclosure, drawings which need to be used therein will be introduced below briefly. It should be understood that the drawings below merely show some implementations of the present disclosure, and therefore should not be considered as limitation to the scope. Those ordinarily skilled in the art still could obtain other relevant drawings according to these drawings, without using any creative efforts.
FIG. 1 is a schematic diagram of arrangement of welding strips, fine grid lines, and colloids of a cell provided in the present disclosure;
FIG. 2 is a schematic diagram of connection between two adjacent cells and arrangement of welding strips, fine grid lines, and colloids provided in the present disclosure;
FIG. 3 is a flowchart of a packaging method for a solar cell module provided in an embodiment of the present disclosure;
FIG. 4 is a flowchart of step S2 in FIG. 3;
FIG. 5 is a flowchart of a connection method for a solar cell string provided in the present disclosure;
FIG. 6 is a schematic illustration of a connection manner of welding strips and a cell provided in the present disclosure;
FIG. 7 is a flowchart of another manufacturing method for a solar cell module provided in the present disclosure;
FIG. 8 is a schematic diagram of a structure obtained after step S41 in an embodiment of the present disclosure;
FIG. 9 is a schematic diagram of a structure obtained after step S42 in an embodiment of the present disclosure;
FIG. 10 is a schematic diagram of a structure obtained after step S43 in an embodiment of the present disclosure;
FIG. 11 is a schematic diagram of a structure obtained after step S44 in an embodiment of the present disclosure;
FIG. 12 is a flowchart of another connection method for a solar cell string provided in the present disclosure;
FIG. 13 is a schematic diagram of a structure obtained after step S51 in an embodiment of the present disclosure;
FIG. 14 is a schematic diagram of a structure obtained after step S52 in an embodiment of the present disclosure;
FIG. 15 is a schematic diagram of a structure obtained after step S53 in an embodiment of the present disclosure; and
FIG. 16 is a schematic diagram of a structure obtained after step S54 in an embodiment of the present disclosure.

Reference signs: 1, 100 cell; 11 first cell; 12 second cell; 2, 200 welding strip; 21, 210 first welding strip; 22, 220 second welding strip; 3, 300 fine grid line; 31 first fine grid line; 32 second fine grid line; 4, 400 colloid; 41 first colloid; 42 second colloid.

### Detailed Description of Embodiments

In order to make objectives, technical solutions, and advantages of the embodiments of the present disclosure clearer, the technical solutions in the embodiments of the present disclosure will be described clearly and completely below in conjunction with drawings in the embodiments of the present disclosure, and apparently, the embodiments described are some but not all embodiments of the present disclosure. Generally, components in the embodiments of the present disclosure, as described and shown in the drawings herein, may be arranged and designed in a variety of different configurations.

Therefore, the detailed description below of the embodiments of the present disclosure provided in the drawings is not intended to limit the scope of the present disclosure claimed, but merely illustrates chosen embodiments of the present disclosure. All of other embodiments obtained by those of ordinary skill in the art based on the embodiments of the present disclosure without any creative efforts shall fall within the scope of protection of the present disclosure. In the above, terms "first", "second", "third", etc. are merely for distinguishing the description, but should not be construed as indicating or implying importance in the relativity.

It should be noted that similar reference signs and letters represent similar items in the following drawings, therefore, once a certain item is defined in one drawing, it is not needed to be further defined or explained in subsequent drawings.

Embodiments of the present disclosure will be described in detail below in combination with embodiments, while a person skilled in the art could understand that the following embodiments are merely used for illustrating the present disclosure, but should not be considered as limitation on the scope of the present disclosure. If no specific conditions are specified in the embodiments, it should be carried out under normal conditions or conditions recommended by manufacturers. If manufacturers of reagents or apparatuses used are not specified, the reagents or apparatuses are conventional products commercially available.

Based on the problems existing in the related art, in a first aspect, there is provided a packaging method for a solar cell module, which, without increasing the manufacturing process and material costs, can greatly reduce the consumption of silver paste for the cell module, and greatly save the overall costs of cells and the cell module.

A packaging method for a solar cell module is mainly for improving the battery series welding process in the packaging process of a cell module. In the present embodiment, a surface of the cell is only printed with fine grid lines, and is not printed with main grid lines or fine main grid lines, wherein an electrical connection is implemented by making a welding strip in direct contact with the fine grid lines, and by the way that the cell and the welding strip are fixed, so that a plurality of cells are connected in series to be made into a cell string, i.e., a current collecting function of the solar cell module can be realized, the consumption of silver paste can also be greatly reduced, and the cost of the cell module is saved.

In the above, as the diameters of welding strip and the fine grid lines on the cell is relatively small, it is necessary to ensure the electrical connection between the welding strip and the fine grid lines and the fixed connection between the welding strip and the cell during implementation.

That is, a plurality of welding strips are uniformly arranged at intervals in a direction perpendicular to the fine grid lines on the surface of each cell. In the above, each welding strip is perpendicular to each fine grid line on a surface of a corresponding cell.

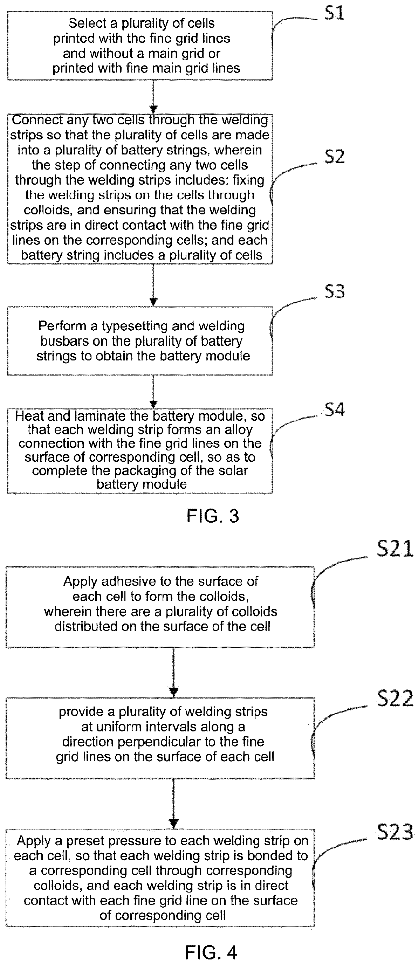

As shown in FIG. 3, the packaging method for a solar cell module includes the following steps:
step S1, selecting a plurality of cells printed with the fine grid lines and without a main grid line or printed with fine main grid lines.

Each of the cells in the solar cell module to which the packaging method for a solar cell module in the first aspect is directed is a cell without main grid lines. Optionally, neither a front surface nor a back surface of each cell is printed with the main grid lines, and they are only printed with the fine grid lines. Optionally, the cells in the present embodiment may be heterojunction cells, also may be TOPCON (Tunnel Oxide Passivated Contact) cells, or PERC (Passivated Emitter and Rear Cell).

Optionally, the number of fine grid lines on the front surface and the back surface of each cell ranges from15 to 35.

Step S2, connecting any two cells through the welding strips so that the plurality of cells are made into a plurality of cell strings, wherein the step of connecting any two cells through the welding strips includes: fixing the welding strips on the cells through colloids, and ensuring that the welding strips are in direct contact with the fine grid lines on the corresponding cell; and each cell string includes a plurality of cells.

Optionally, when connecting any two cells through the welding strips, in the present embodiment, the colloids are provided on the cells, and the welding strips are bonded to the cells through the colloids, so that a mechanical connection between the welding strips and the cells is achieved; the electrical connection is implemented by making each welding strip in direct contact with the fine grid lines printed on the surface of the cells, so that the current collecting function of the cell module is realized. In this way, as there is no need to print the main grid lines on the cells, the consumption of silver paste for the cell module can be greatly reduced.

Specifically, when fixing the welding strips on the cells, as shown in FIG. 4, step S2 further includes:
step S21, applying adhesive to the surface of each cell to form the colloid. In an embodiment, there are a plurality of colloids distributed on the surface of the cell.

The colloids in the present embodiment are configured to fix the welding strip on the cell. Optionally, the colloids are non-conductive adhesive.

In a practical production process, distribution positions of the welding strips and distribution positions of the colloids can be designed on the surface of each cell in advance, then the adhesive is applied to the distribution positions of the colloids to form the colloids, and after that, the welding strips are arranged at corresponding positions on the surface of the cell.

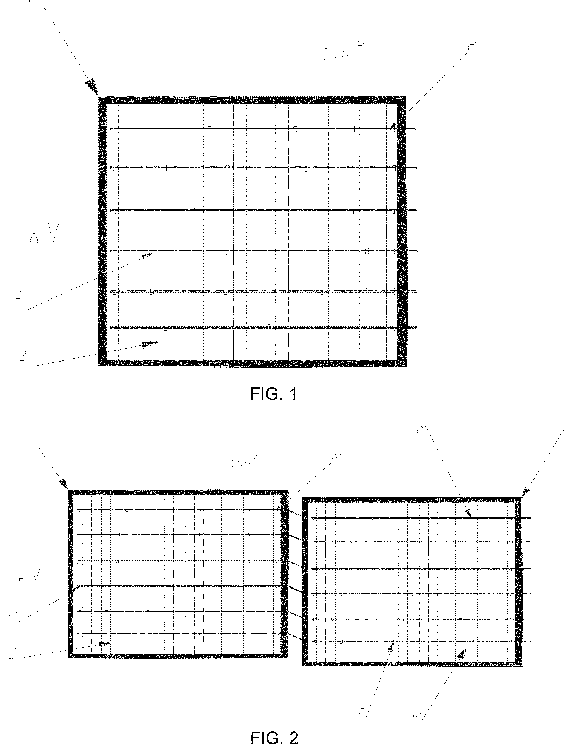

Optionally, since the colloids are non-conductive adhesive, the distribution positions of the colloids in the present embodiment do not overlap contact positions of the welding strips and the fine grid lines, thus avoiding affecting the electrical connection between the welding strips and the fine grid lines. Optionally, in the present embodiment, the positions of the colloids do not overlap contact positions of the fine grid lines and the welding strips, and the consumption of adhesive for the colloids is relatively few, which can avoid the problem of electrical failure of the fine grid lines and the welding strips caused by the flow of the colloids in processes of pre-welding and fixing. As shown in FIG. 1, the colloids 4 are distributed at junctions of welding strips 2 and a cell 1, and in order to avoid the problem of electrical failure of fine grid lines 3 and the welding strips 2, distribution positions of colloids 4 do not contact the fine grid lines 3, but are only configured to fix the welding strips 2, which are thus fixed on the surface of the cell 1.

Optionally, for each welding strip 2, there are at least two colloids 4. That is, each welding strip is bonded to the surface of the cell by at least two colloids 4. However, without being limited to this, the number of colloids can be determined through experiments in accordance with the dimension of the cell and the consumption of adhesive.

For another example, as shown in FIG. 2, which is a schematic diagram of the connection between two adjacent cells, a plurality of first fine grid lines 31 and a plurality of first welding strips 21 perpendicular to the first fine grid lines 31 are provided on a front cell surface of a first cell 11.

A front cell surface of a second cell 12 is provided with a plurality of second fine grid lines 32 and a plurality of second welding strips 22 perpendicular to the second fine grid lines 32.

The first fine grid lines 31 are electrically connected to corresponding first welding strips 21, and the first welding strips 21 are fixed on the front cell surface of the first cell 11 through first colloids 41 so that the first welding strips 21 and the first cell 11 are fixed and form a mechanical connection. Likewise, the second fine grid lines 32 are electrically connected to corresponding second welding strips 22, and the second welding strips 22 are fixed on the front cell surface of the second cell 12 through second colloids 42 so that the second welding strips 22 and the second cell 12 are fixed and form a mechanical connection.

Positions where the first colloids 41 and the second colloids 42 are located do not overlap contact positions of corresponding welding strips and fine grid lines.

Another part of the plurality of first welding strips 21 are arranged on a back cell surface (not shown in the drawings) of the second cell 12 in the same manner; and likewise, another part of the plurality of second welding strips 22 are arranged on a back cell surface of an adjacent cell connected in series with the second cell 12 in the same manner.

Step S22, uniformly providing a plurality of welding strips at intervals along a direction perpendicular to the fine grid lines on the surface of each cell. In the above, each welding strip is perpendicular to each fine grid line on a corresponding cell surface.

Surfaces of the cell include a front cell surface and a back cell surface. In the prior art, both the front cell surface and the back cell surface are printed with the fine grid lines and the main grid lines. The cell to which the packaging method for a solar cell module in the first aspect is directed is a main-grid-free cell, that is, there are only the fine grid lines on the front cell surface and the back cell surface, but without the main grid line. As shown in FIG. 1, for the cell 1, both the front cell surface and the back cell surface are printed and arranged with a plurality of fine grid lines 3. When the welding strips 2 are arranged on the surfaces of the cell 1, the welding strips 2 are arranged on the surfaces of the cell 1 at a predetermined spacing distance. Adjacent welding strips 2 have the predetermined spacing distance therebetween, and each welding strip 2 is perpendicular to each fine grid line 3 on the surfaces of the cell 1. As can be seen from FIG. 1, a direction A is an extending direction of the fine grid lines 3, i.e., an arrangement direction of the welding strips 2; and a direction B is an extending direction of the welding strips 2, i.e., an arrangement direction of the fine grid lines 3. In the above, the cells in the present embodiment all refer to solar cells.

A plurality of welding strips 2 perpendicular to the fine grid lines 3 are provided at intervals in sequence along the direction perpendicular to the fine grid lines 3.

In a process of packaging a cell module, firstly, a plurality of cells need to be connected in series to be made into a cell string, and then a plurality of cell strings are typesetted, reflow-soldered, and then laminated to obtain a cell string laminate. Therefore, a plurality of cells are connected in series through the welding strips to be made into the cell string in the present embodiment. That is, by providing one or more welding strips between adjacent cells, the connection between two adjacent cells is realized, and further a plurality of cells are made into the cell string.

In the above, for two adjacent cells in the cell string, each welding strip has one part arranged on a front surface of one cell, and the other part arranged on a back surface of the other cell. In this way, a plurality of cells can be connected in series to be made into a cell string, so as to facilitate subsequent typesetting and lamination and obtain the cell string laminate.

Step S23, applying a preset pressure to each welding strip on each cell, so that each welding strip is bonded to a corresponding cell through corresponding colloids, and each welding strip is in direct contact with each fine grid line on the surface of the corresponding cell.

After wiring is performed on the surface of the cell, a certain pressure is applied to the welding strips, so that each welding strip is in direct contact with corresponding colloids, and is bonded to the cell through the colloids. Moreover, under the effect of the pressure applied, each welding strip is also in direct contact with each fine grid line to implement the electrical connection.

In the practical application process, a plurality of welding strips are uniformly arranged by a wiring mechanism along the extending direction perpendicular to the fine grid lines on the surface of the cell, ensuring that any two adjacent welding strips have the same spacing distance therebetween.

Optionally, the welding strip is a copper strip with a coating. In the above, the coating may be a tin coated layer, a SnBiAg (silver tin bismuth) alloy layer, or other low-melting-point metal layer or alloy layer. In the present disclosure, by providing a low-melting-point metal coating or alloy coating on an outer layer of the welding strip, it can be ensured in subsequent processes that the coating of the welding strip and the silver paste of the fine grid lines easily form a good alloy connection by means of heating. Due to the relatively low melting point of the coating, a heating temperature does not need to be too high, facilitating process operations.

Optionally, the low-melting-point metal layer or alloy layer has a melting point ranging from 120 °C to 160 °C.

In addition, each solar cell module is obtained by connecting a plurality of cells in series, and two adjacent cells are connected together through the welding strips. Therefore, when wiring is performed, one welding strip has one part being wired on the front surface of one of the adjacent cells, and the other part being wired on the back surface of the other one of the adjacent cells.

In the present embodiment, for the wiring process operations of the welding strips, compared with the wiring of existing welding strips, as the cell to which the packaging method for a solar cell module in the first aspect is directed is a main-grid-free cell, the step of printing the main grid lines is omitted in the manufacture of the cell. Besides, in the packaging of the solar cell module, as the cell does not have main grid lines or only contains the fine main grid lines, the arrangement of welding strip fixing points, i.e., positions of the colloids, has a high degree of freedom.

Optionally, by applying the adhesive to the surface of the cell to form the colloids in advance before wiring the welding strips, the mass production can be improved, and the bonding strength per unit area between the non-conductive adhesive and the welding strip can be increased and the consumption of adhesive can be reduced.

Optionally, before step S23, the method further can include: pre-welding each welding strip on each cell, so that each welding strip is fixed on the surface of the corresponding cell, and each welding strip is in direct contact with the fine grid lines on the surface of corresponding cell.

In the above, a manner of pre-welding is any one of infrared heating, heat conduction, induction heating, and heat sealing heating.

Moreover, as the colloids are provided at the welding strip fixing points on the surface of the cell, when pre-welding the welding strips, the colloids can be heated, so that the welding strips are bonded to the surface of the cell through the colloids, and the mechanical connection is formed between the welding strips and the surface of the cell. Moreover, in the process of laminating the welding strips, the welding strips are brought to be a tight contact with the fine grid lines on the surface of the cell, that is, welding points and the fine grid lines are made to implement an electrical connection.

By pre-welding the welding strips and applying the pressure thereto, it not only can ensure that the welding strips are fixed on the surface of the cell, but also can ensure that the welding strips are a tight contact with the fine grid lines on the cell, thus ensuring the electrical connection between the welding strips and the fine grid lines.

Optionally, the colloids can be selected from hot-melt adhesive, photosensitive adhesive, adhesive tape, or the like.

As the colloids are formed by the adhesive in the present embodiment, the consumption of adhesive is relatively few, which can solve the problem of electrical failure of the welding strips and the fine grid lines caused by a large consumption of adhesive in the related art.

First, the welding strips are bonded to the cell through the colloids, which not only can ensure that a plurality of cells are connected in series to be made into the cell string, but also can ensured that the welding strips do not move on the cell, thus preparing for a next step of packaging of the cell module.

In the present embodiment, first, the colloids are provided on the surface of each cell; then the welding strips are arranged on the surface of the cell, so that the welding strips are perpendicular to the fine grid lines; finally, the welding strips are fixed on the cell through the colloids and the welding strips are brought into tight contact with the corresponding fine grid lines by means of pre-welding and/or fixing. In this way, it not only can ensure that the welding strips will not move during the manufacturing process, and the mechanical connection between the welding strips and the cell is ensured, but also can ensure that the tight contact between the welding strips and the fine grid lines implements a stable electrical connection. Moreover, as the adhesive is applied before the wiring, it is more convenient to be operated, and conducive to be implemented for mass production in the practical production process.

Step S3, performing typesetting and welding bus bars on the plurality of cell strings to obtain the cell string laminate.

As any two adjacent cells in the cell string are connected together through the welding strips, and a relatively strong mechanical connection is formed, the plurality of cell strings can be directly typesetted, and then the bus bars are welded on the plurality of typesetted cell strings, so as to ensure that the plurality of cell strings are made into the cell module.

Step S4, heating and laminating the cell strings, so that each welding strip forms an alloy connection with the fine grid lines on the surface of corresponding cell, so as to complete the packaging of the solar cell module.

Optionally, a temperature range of heating and laminating is from 130 °C to 170 °C.

As the coating of the welding strips is a low-melting-point metal layer or alloy layer in the present embodiment, wherein a melting point temperature is from 120 °C to 160 °C, when heating and laminating, the temperature can reach the melting point of the coating, thus, the coating on the surface of welding strip can form a good alloy connection with the silver paste of the fine grid lines.

Optionally, the coating is a tin layer or a SnBiAg alloy layer. Therefore, in the packaging method for a solar cell module in the first aspect, since it is unnecessary to print the main grid lines on the cell, and the welding strip is directly electrically connected to the fine grid lines, the consumption of silver paste is greatly reduced, and the electrical conductivity of the cell can also be improved. Optionally, the present embodiment is more applicable to the packaging of cells with a huge amount of fine grid lines. Specifically, the present embodiment is applied to cells with the number of fine grid lines ranging from 15 to 35.

Compared with the manner of increasing the number of main grid lines in related art, the packaging method for a solar cell module in the first aspect does not require printing the main grid lines on the cell, thus the manufacturing cost of the cell module can be greatly reduced; compared with the manner of using the intelligent wire, as no manufacturing steps need to be added in the present embodiment, only the existing series welding process of cells is correspondingly adjusted, and no additional manufacturing equipment and manufacturing processes need to be added, thus the manufacturing costs are further saved; moreover, the welding strip in the present disclosure is a common existing welding strip, without the need of coating a polymeric film layer on the copper strip, saving the material costs, therefore, compared with the manner with the intelligent wire, it not only can greatly reduce the consumption of silver paste, but also achieve real cost reduction of the costs of the cell module.

Optionally, before heating and laminating the cell string laminate in step S4, to avoid movement of the welding strips, each welding strip is limited by a pre-crosslinked packaging film in the present embodiment. By means of limiting and fixing the welding strips, the welding strips can be prevented from moving on the surface of the cell, so that the problem that the welding strips are easy to move and the connection thereof is poorly implemented during lamination is solved, and good contact between each welding strip and the fine grid lines on the surface of corresponding cell can be ensured, further implementing the relatively stable mechanical connection and the alloy electrical connection.

In the above, the pre-crosslinked packaging film in the present embodiment is a packaging adhesive film with low fluidity. By using the packaging adhesive film with low fluidity, in the process of heating and laminating, the packaging adhesive film will not flow, which not only does not drive displacement of the welding strips, but also can well fix the welding strips on the surface of the cell, and press the welding strips so that the welding strips are in tight contact with the fine grid lines on the surface of the cell, thereby forming good alloy contact.

Optionally, the pre-crosslinked packaging film is made of any packing material of EVA, POE, and PVB. In the above, EVA refers to an ethylene-vinyl acetate copolymer and a rubber-plastic foam material made thereof. POE is an ethylene-octene copolymer. PVB refers to polyvinyl butyral.

In a second aspect, a solar cell module is further provided. The solar cell module is a solar cell module manufactured by the packaging method for a solar cell module according to the first aspect.

The cell to which the packaging method for a solar cell module in the first aspect is directed is a main-grid-free cell, wherein the front surface and the back surface of the cell are only printed with the fine grid lines. By means of making the welding strips and the fine grid lines in direct contact to implement an electrical connection, and forming a mechanical connection between cells and the welding strips through the low-cost non-conductive adhesive to allow the welding strips to be fixed on the cells, not only the conductive function of the solar cell module can be ensured, but also the mechanical connection between the plurality of cells can be realized. Also, as the surfaces of the cells do not need to be printed with the main grid lines, and any other materials and manufacturing costs are not added, the consumption of silver paste for the cell module is significantly reduced, the manufacturing costs of the cell module is saved, and the number of cell modules is reduced. Moreover, this packaging method does not need to add any process flow, and can be achieved by directly using existing technological devices, which is convenient for operations and saves the manufacturing costs.

In addition, the inventors of the present disclosure found during research that, if the adhesive is first used on the cells and then the welding strips are arranged for the connection, as the height of the adhesive is not easy to control when applying the adhesive, the height of the adhesive is likely to be too high and causes a relatively large gap between the welding strips and the fine grids, which may cause poor conduction between the welding strips and the fine grid lines.

In a third aspect, a connection method for a solar cell string is provided, which can avoid the problem that a gap exists between the welding strips and the fine grid lines due to the adhesive is too high when the adhesive is applied, and thus can improve the problem of poor conduction between the welding strips and the fine grid lines on the cells.

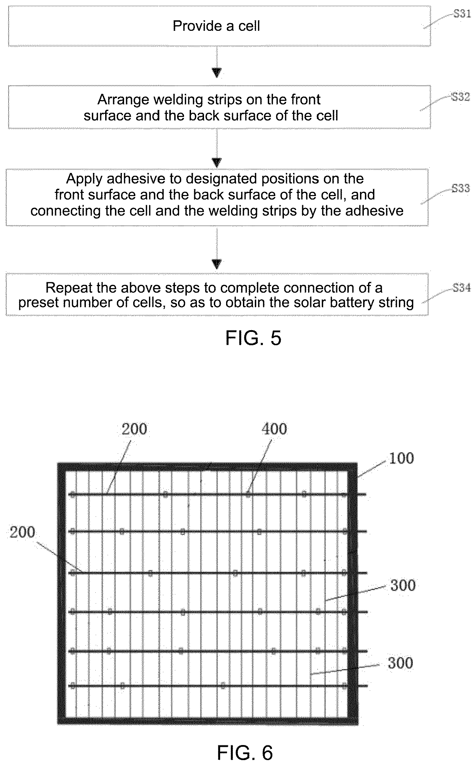

Referring to FIG. 5, the connection method for a solar cell string includes following steps:
S31, providing a cell 100.

Exemplarily, a front surface and a back surface of the cell 100 have no main grid line or contain fine main grid lines. It should be noted that the main grid line refers to a structure having a pad on the fine main grid lines. That is to say, the front surface and the back surface of the cell 100 can be printed with fine grid lines 300, but without the main grid line, which can save the consumption of silver paste and thus can save the costs. In addition, it is also feasible that both the front surface and the back surface of the cell 100 are printed with the fine grid lines 300 and the fine main grid lines, i.e., the pad on the fine main grid line is not printed, which also can save the consumption of silver paste.

Optionally, the number of fine grid lines 300 on each of the front surface and the back surface of the cell 100 ranges from 15 to 35, for example, at least one numerical value of 15, 20, 25, 30, and 35 or a range between any two values thereof. In an embodiment, the fine grid lines 300 are all distributed on the front surface and the back surface of the cell 100 at a certain spacing distance.

Exemplarily, the cell 100 may be any one of a heterojunction cell, a TOPCON cell, and a PERC cell.

S32: arranging welding strips 200 on the front surface and the back surface of the cell 100.

Exemplarily, when arranging the welding strips 200 on the front surface and the back surface of the cell 100, the plurality of welding strips 200 are arranged perpendicular to the fine grid lines 300 on the cell 100. In the above, the plurality of welding strips 200 are arranged at a certain spacing distance from each other. It should be noted that optionally, when arranging the welding strips 200, an included angle between an welding strip 200 and an fine grid line 300 also may be an acute angle.

S33: applying adhesive to designated positions on the front surface and the back surface of the cell 100 to form colloids 400, and connecting the cell 100 with the welding strips 200 through the colloids 400.

Exemplarily, the designated positions on the front surface and the back surface of the cell 100 are determined by marks screen-printed on the cell 100, wherein when screen-printing the fine grid lines 300, a plurality of marks are printed on the cell 100, and the marks can be determined as designated positions with the adhesive. Optionally, the designated positions may be on part of the fine grid lines 300, and also may be positions between the fine grid lines 300 (see FIG. 6).

Exemplarily, when the designated positions with the adhesive are on the fine grid lines 300, after the welding strips 200 are arranged on the front surface and the back surface of the cell 100, the adhesive is applied to positions where the welding strips 200 overlap the fine grid lines 300 to form the colloids, so that the cell 100 is connected to the welding strips 200. Exemplarily, when the designated positions for applying the adhesive are at positions between the fine grid lines 300, after the welding strips 200 are arranged on the front surface and the back surface of the cell 100, the adhesive is applied to positions where the welding strips 200 do not overlap the fine grid lines 300 to form the colloids, so that the cell 100 is connected to the welding strips 200.

Optionally, the adhesive used in the step of applying the adhesive is at least one of hot-melt adhesive, photosensitive adhesive, and an adhesive tape. When the adhesive tape is used for bonding, whether the designated positions are on part of the fine grid lines 300 or between the fine grid lines 300, the adhesive tape is just directly adhered to an upper surface of each welding strip 200 and is connected to the cell 100.

Optionally, each welding strip 200 has at least two connection points with one cell 100. As there are at least two connection points, the welding strip 200 can be more stably connected to the cell 100 , and the welding strip 200 is not easy to be displaced.

Optionally, the colloids in the embodiments of the present disclosure may be conductive adhesive or non-conductive adhesive. As the welding strips 200 are first arranged on the cell 100, and then the adhesive is applied to form the colloids to bond the cell 100 and the welding strips in the embodiment of the present disclosure, whether conductive adhesive or the non-conductive adhesive is used, and the positions of using the adhesive are on part of the fine grid lines 300 or between the fine grid lines 300, after the cell 100 is bonded to the welding strips 200, it can be relatively easy for the welding strips 200 and the fine grid lines 300 on the cell 100 to contact, so that the welding strips 200 and the fine grid lines 300 enable a good electrical contact.

In some embodiments, after step S32 and before step S33, further included is: a step of enabling a preliminary connection between the welding strips 200 and the fine grid lines 300 of the cell 100 by heating.

First, the welding strips 200 are arranged on the surface of the cell 100, then the preliminary connection between the welding strips 200 and the fine grid lines 300 is implemented by means of heating, then the colloids 400 are formed at designated positions on the front surface and the back surface of the cell 100, and the cell 100 is connected to the welding strips 200 through the colloids 400, which can further improve the connection stability of the welding strips 200 and the cell 100, and can further improve the electrical contact between the welding strips 200 and the fine grid lines 300, thus, the problem of poor conduction between the welding strips 200 and the cell 100 is further solved.

In the above, it should be noted that, the preliminary connection formed by the welding strips 200 and the fine grid lines 300 on the cell 100 may be preliminary contact of the welding strips 200 and the fine grid lines 300, and also may be a relatively weak alloy connection formed by welding strips 200 and the fine grid lines 300, in this case the welding strips 200 may be separated from the fine grid lines 300 by a relatively less force. Subsequently, the welding strips 200 and the grid lines 300 can form tight contact or a relatively strong alloy connection after being laminated and heated, and a greater force is required to separate the welding strips 200 from the fine grid lines 300. In an embodiment, both the preliminary contact and the tight contact refer to a state in which the welding strips 200 and the fine grid lines 300 on the cell 100 are in mechanical contact, while the alloy connection is not formed.

Exemplarily, a separating force after the preliminary connection between the welding strips 200 and the fine grid line 300 is formed ranges from 0.03N to 0.1 N, which can ensure that the welding strips 200 do not move on the cell 100 without an external force, and makes the contact of the welding strips 200 and the fine grid lines 300 more tight. It should be noted that, the separating force refers to a force required for separating the welding strips 200 and the fine grid lines 300 after the preliminary connection between the welding strips 200 and the fine grid lines 300 is formed. Optionally, the separating force after the preliminary connection between the welding strips 200 and the fine grid lines 300 is formed is any one of 0.03 N, 0.04 N, 0.05 N, 0.06 N, 0.06 N, 0.07 N, 0.08 N, 0.09 N, and 0.1 N or a range between any two thereof.

In some embodiments, heating manners include at least one of infrared heating, thermal conduction, induction heating, and hot air heating. Exemplarily, a heating temperature of forming the preliminary connection between the welding strips 200 and the fine grid lines 300 ranges from 100°C to 250 °C, for example, any one of 100 °C, 120 °C, 140 °C, 150 °C, 170 °C, 180 °C, 200 °C, 220 °C, 240 °C, and 250 °C or a range between any two thereof.

In some embodiments, each welding strip 200 is a copper welding strip 200 having a coating on an entire surface, wherein the coating includes a metal layer or an alloy layer with a melting temperature ranging from 120 to 160 °C. As the metal layer or the alloy layer has a relatively low melting temperature, a good connection between the welding strips 200 and the fine grid lines 300 can be achieved through a relatively low heating temperature. Moreover, in the subsequent laminating and heating processes, a good connection between the welding strips 200 and the fine grid lines 300 also can be realized through a relatively low temperature, thus the process operations can be facilitated. Optionally, the melting temperature of the metal layer or the alloy layer is any one of 120 °C, 130 °C, 140 °C, 150 °C, and 160 °C or a range between any two thereof.

Optionally, the coating is a Sn alloy layer, and the Sn alloy layer has a relatively low melting temperature, then a good connection between the welding strips 200 and the fine grid lines 300 can be achieved through a relatively low laminating and heating temperature. Exemplarily, the Sn alloy layer is a SnBiAg alloy layer.

Optionally, each welding strip 200 has a thickness ranging from 0.1mm to 0.3 mm, for example, any one of 0.1 mm, 0.2 mm, and 0.3 mm or a range between any two thereof.

Exemplarily, the welding strips 200 may be segmented welding strips, that is to say, one welding strip 200 may have more than one cross-section shape, for example, a cross section of a part of connection between the welding strip 200 and the front surface of the cell 100 is of one shape, and a cross section of a part of connection between the welding strip 200 and the back surface of the cell 100 is of another shape. In the above, the cross sections of the welding strip 200 may be at least one of a circle and a triangle, and a surface of the welding strip 200 in contact with the cell 100 also may be a flat surface.

S34: repeating the above steps to complete connection of a preset number of cells 100, and obtaining the solar cell string.

In some embodiments, after step S33 and before step S34, further included is: a step of curing the colloids 400.

The colloids 400 are cured after the welding strips 200 are connected to the cell 100 through the colloids 400, then the connection stability between the welding strips 200 and the cell 100 can be improved, so that the welding strips 200 are less likely to be displaced, which is more beneficial to improve the good electrical contact between the welding strips 200 and the fine grid lines 300. Optionally, the manner of curing the colloids 400 includes heating, providing lighting or hot-pressing. In the above, when heat-sensitive adhesive is selected as the colloids 400, the colloids 400 can be cured by heating; when the photosensitive adhesive is selected as the colloids 400, the photosensitive adhesive can be cured by providing lighting; and when heat-pressure-sensitive adhesive is used, the colloids 112 can be cured by means of hot-pressing.

In a fourth aspect, another connection method for a solar cell string is provided, specifically illustrated as follows.

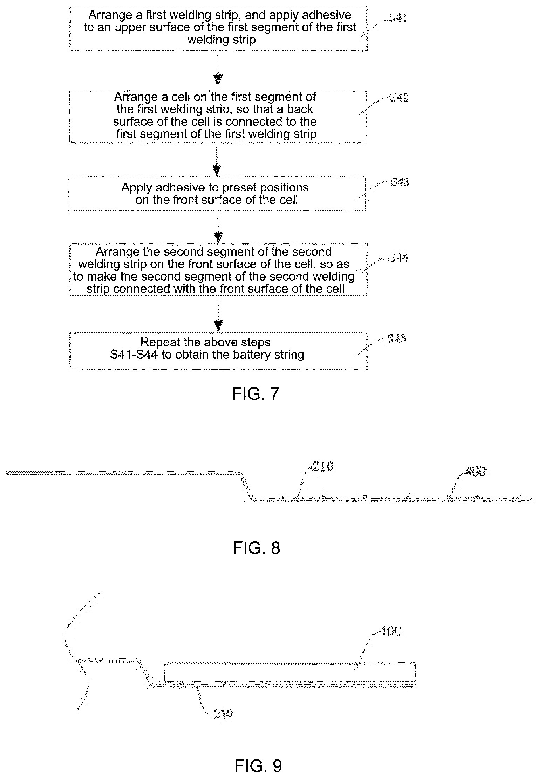

FIG. 7 shows a flowchart of a connection method for a solar cell string in the fourth aspect, wherein the cell string includes a plurality of cells connected in series, two adjacent cells are connected together through welding strips, the welding strips are segmented welding strips, each including a first segment and a second segment, and specific steps of the connection method include:
S41, arranging a first welding strip 210, and applying adhesive to an upper surface of the first segment of the first welding strip 210 to form colloids 400 (see FIG. 8).

Exemplarily, when arranging the first welding strip 210, a plurality of welding strips are arranged, wherein the plurality of first welding strips 210 are arranged at intervals of a certain spacing distance. Optionally, the plurality of first welding strips 210 are arranged in parallel.

S42, arranging a cell 100 on the first segment of the first welding strip 210, so that a back surface of the cell 100 is connected to the first segment of the first welding strip 210 (see FIG. 9).

Since the adhesive is applied to the upper surface of the first segment of the first welding strip 210, and then the cell 100 is arranged on the upper surface of the first segment of the first welding strip 210 for bonding, the adhesive 400 will not easily drip on the upper surface of the first welding strip 210, so that the problem of poor bonding effect between the welding strip and the cell 100 caused by the adhesive dripping can be avoided.

Optionally, the upper surface of the first segment of each first welding strip 210 is a flat surface. As the adhesive needs to be applied to the upper surface of the first segment of the welding strip, the upper surface of the first segment of the first welding strip 210 is provided as a flat surface, so that it is easy to apply the adhesive to the upper surface of the first segment, and the adhesive will not easily drip from the upper surface, thus facilitating the subsequent stable connection between the first segment 220 of the first welding strip 210 and the cell 100.

Optionally, the upper surface of the first segment of the first welding strip 210 has a width ranging from 0.2 to 1.2 mm. The upper surface within this width range is beneficial to more stably dispense the adhesive on the welding strip and the adhesive is not easy to drip. Exemplarily, the width of the upper surface is any one of 0.5 mm, 0.6 mm, 0.7 mm, 0.8 mm, 0.9 mm, 1.0 mm, 1.1 mm, and 1.2 mm or a range between any two thereof. It should be noted that, the lower surface of the first segment may be a flat surface, a cambered surface, or of other shapes, which is not specifically limited in the embodiments of the present disclosure.

Optionally, a cross section of the second segment of a second welding strip 220 includes at least one of a circle and a triangle.

Optionally, a front surface and the back surface of the cell 100 have no main grid line or contain fine main grid lines. That is to say, the grid lines on the front surface and the back surface of the cell 100 only contain fine grid lines, or contain fine grid lines and fine main grid lines without the bonding pad. In addition, it should be noted that, the cell 100 also may be a cell 100 containing the main grid lines.

In some embodiments, when arranging the cell 100 on the first segment of each first welding strip 210, the fine grid lines on the cell 100 are arranged in a perpendicular relationship with the first welding strip 210.

Optionally, the number of fine grid lines on the front surface of the cell 100 ranges from 15 to 35, and the number of fine grid lines on the back surface of the cell 100 is also 15 to 35. In the above, the fine grids on the front surface of the cell 100 are distributed on the surface of the cell 100 at certain intervals, and the fine grid lines on the back surface of the cell 100 are also distributed on the surface of the cell 100 at certain intervals. Exemplarily, the cell 100 is any one of heterojunction cell, TOPCON cell, and PERC cell.

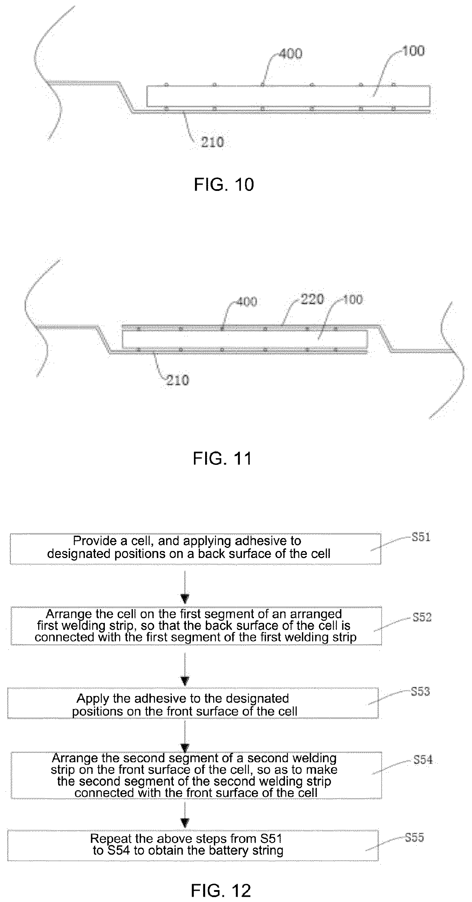

S43: applying adhesive to preset positions on the front surface of the cell 100 to form the colloids 400 (see FIG. 10).

Exemplarily, the preset positions on the front surface of the cell 100 are determined by marks screen-printed on the cell 100. When screen-printing the fine grid lines, a plurality of marks are printed on the cell 100, and the marks can be determined as preset positions for applying the adhesive. Optionally, the preset positions are on part of the fine grid lines. It can be understood that the preset positions also may be positions between two adjacent fine grid lines, rather than on the fine grid lines.

S44: arranging the second segment of the second welding strip 220 on the front surface of the cell 100, so as to make the second segment of the second welding strip 220 connected with the front surface of the cell 100 (see FIG. 11).

As the adhesive is applied to the preset positions on the front surface of the cell 100, then the second welding strip 220 is placed on the front surface of the cell 100 for bonding, the adhesive dispensed on the front surface of the cell 100 is not easy to drip, therefore, the problem of poor bonding effect between the cell 100 and the welding strip caused by the adhesive dripping can be avoided. Exemplarily, when arranging the second welding strip 220, a plurality of welding strips are arranged, wherein the plurality of second welding strips 220 are arranged at intervals of a certain spacing distance. Optionally, the plurality of second welding strips 220 are arranged in parallel.

Optionally, when arranging the second segments of the second welding strips 220 on the front surface of the cell 100, the plurality of second welding strips 220 are arranged in a perpendicular relationship with the fine grid lines on the cell 100.

S45: repeating the above steps from S41 to S44 to obtain the cell string.

That is to say, after the second segments of the second welding strips 220 are connected to the front surface of the cell 100, the adhesive continues to be applied to the upper surfaces of the first segments of the second welding strips 220, then another cell 100 is arranged on the upper surfaces of the first segments of the second welding strips 220, after a back surface of the another cell 100 is connected to the first segments of the second welding strips 220, steps that need to be repeated are performed in sequence, and finally, a plurality of cells 100 are connected in series to be made into the cell string.

Optionally, the colloids used are conductive adhesive or non-conductive adhesive. In either case of using the conductive adhesive or the non-conductive adhesive, good electrical contact can be formed between the cells and the welding strips. Exemplarily, the colloids used are non-conductive adhesive, and the preset positions are not on the fine grid lines. When the non-conductive adhesive is used, and the positions for applying the adhesive are not on the fine grid lines, for example, are between two fine grid lines, when connecting the welding strips and the cells 100, it is beneficial for the contact between the welding strips and the fine grid lines, thus better electrical contact can be formed between the welding strips and the fine grid lines on the cells 100. Optionally, the colloids used include at least one of hot-melt adhesive and photosensitive adhesive.

Exemplarily, between step S44 and step S45, a step of curing the adhesive is further included. After the adhesive is cured, the connection between the welding strips and the cell 100 can be reinforced, thus improving the connection stability. Optionally, the step of curing the adhesive is performed by means of heating, lighting or hot-pressing. Optionally, a temperature for curing the adhesive ranging from 100 °C to 250 °C, for example, any one of 100 °C, 120 °C, 150 °C, 180 °C, 200 °C, and 250 °C or a range between any two thereof.

Optionally, heating manners for curing the adhesive include at least one of infrared heating, thermal conduction, induction heating, and hot air heating.

In the following, the connection method for a solar cell string in the fourth aspect is described by taking connecting two cells as an example, which includes steps of: a) arranging the first welding strip, and applying the adhesive to the upper surface of the first segment of the first welding strip; b) arranging the first cell on the first segment of the first welding strip, so that the back surface of the first cell is connected to the first segment of the first welding strip; c) applying the adhesive to the preset positions on the front surface of the first cell; d) arranging the second segment of the second welding strip to the front surface of the first cell, so that the second segment of the second welding strip is connected to the front surface of the first cell; e) applying the adhesive to the upper surface of the first segment of the second welding strip; f) arranging the second cell on the first segment of the second welding strip, so that the back surface of the second cell is connected to the first segment of the second welding strip; g) applying the adhesive to the presets positions on the front surface of the second cell; and h) arranging a second segment of a third welding strip on the front surface of the second cell, so that the second segment of the third welding strip is connected to the front surface of the second cell, thus obtaining the cell string.

Next, the connection method for a solar cell string in the fourth aspect is described by taking connecting three cells as an example, which includes steps of: the above steps a)∼h) (description is omitted herein); i) applying the adhesive to an upper surface of a first segment of the third welding strip; j) arranging a third cell on the first segment of the third welding strip, so that a back surface of the third cell is connected to the first segment of the third welding strip; k) applying the adhesive to preset positions on a front surface of the third cell; and I) arranging a second segment of a fourth welding strip on the front surface of the third cell, so that the second segment of the fourth welding strip is connected to the front surface of the third cell, thus obtaining the cell string.

In the connection method for a solar cell string in the fourth aspect, the adhesive is applied to the upper surface of the first welding strip, then the cell is arranged on the upper surface of the first segment of the first welding strip for bonding, after that, the adhesive is applied to the preset positions on the front surface of the cell, and the second welding strip is arranged on the front surface of the cell for bonding. As the adhesive is applied to the upper surface of the welding strip and the front surface of the cell, the problem of poor bonding effect between the cell and the welding strips caused by adhesive dripping can be avoided.

In a fifth aspect, a further connection method for a solar cell string is provided.

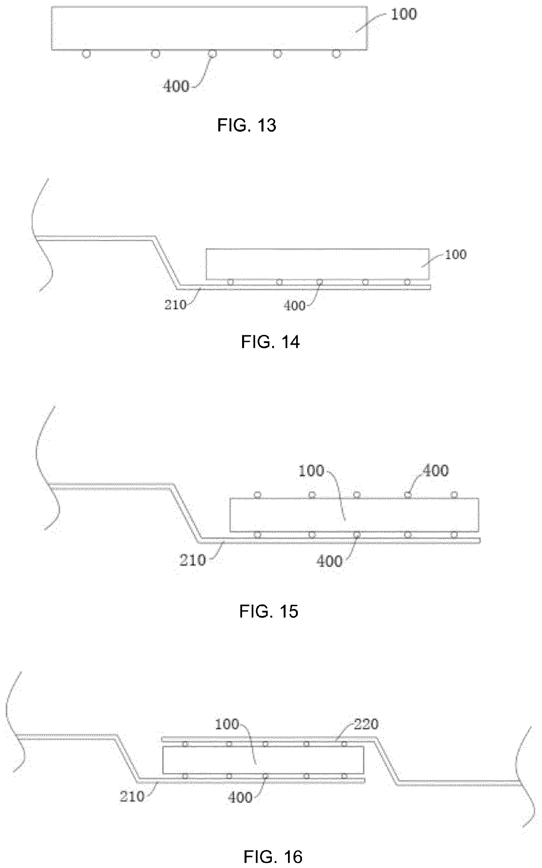

FIG. 12 shows a flowchart of the connection method for a solar cell string in the fifth aspect, wherein the cell string includes a plurality of cells 100 connected in series, two adjacent cells 100 are connected together through welding strips, the welding strips are segmented welding strips, each including a first segment and a second segment, and the connection method includes:
S51: providing a cell 100, and applying adhesive to designated positions on a back surface of the cell 100 to form colloids 400 (see FIG. 13).

Optionally, a front surface and the back surface of the cell 100 both have no main grid line or contain fine main grid lines. The grid lines on the front surface and the back surface of the cell 100 may be only fine grid lines, and also may be fine grid lines and fine main grid lines. Exemplarily, the number of fine grid lines on the front surface and the back surface of the cell 100 ranging from 15 to 35, while the number of fine grid lines is not limited thereto, and may be appropriately increased or reduced according to the design of the cell, for example, the number may be up to 100, that is, the number of fine grid lines may be any integer ranging from 1 to 100. In the above, the fine grid lines are distributed on the front surface and the back surface of the cell 100 at a certain spacing distance.

Optionally, the cell 100 is any one of heterojunction cell, TOPCON cell, and PERC cell.

Further, the designated positions on the cell 100 are determined by marks screen-printed on the cell 100. Exemplarily, the preset positions may be on part of the fine grid lines, and also may be not on the fine grid lines, but at positions between two adjacent fine grid lines.

S52: arranging the cell 100 on the first segment of an arranged first welding strip 210, so that the back surface of the cell 100 is connected with the first segment of the first welding strip 210 (see FIG. 14).

In the above, the arranged first welding strip 210 may be arranged before applying the adhesive to the designated positions on the back surface of the cell 100, and also may be arranged after applying the adhesive to the designated positions on the back surface of the cell 100 to form the colloids 400.

Exemplarily, when arranging the first welding strip 210, a plurality of first welding strips 210 can be arranged, wherein the plurality of first welding strips 210 are arranged at a certain spacing distance.

Optionally, when arranging the cell 100 on the first segment of each arranged first welding strip 210, the fine grid lines on the cell 100 can be made to maintain a perpendicular relationship with the first welding strip 210.

S53: applying the adhesive to the designated positions on the front surface of the cell 100 to form the colloids 400 (see FIG. 15).

S54: arranging the second segment of a second welding strip 220 on the front surface of the cell 100, so as to make the second segment of the second welding strip 220 connected with the front surface of the cell 100 (see FIG. 16).

Exemplarily, when arranging the second welding strip 220, a plurality of second welding strips 220 can be arranged, wherein the plurality of second welding strips 220 are arranged on the front surface of the cell 100 at a certain spacing distance.

In addition, when arranging the second welding strips 220, they can be arranged along a direction perpendicular to the fine grid lines on the front surface of the cell 100.

S55: repeating the above steps from S51to S54 to obtain the cell string.

That is to say, after the second segments of the second welding strips 220 are connected to the front surface of the cell 100, the adhesive is applied to designated positions on a back surface of another cell 100, then the another cell 100 is arranged on the first segments of the second welding strips 220, and the back surface of the another cell 100 is connected to the first segments of the second welding strips 220; the adhesive continues to be applied to designated positions on the front surface of the another cell 100, then steps that need to be repeated are performed in sequence, and finally, a plurality of cells 100 are connected to be made into the cell string.

In the connection method for a solar cell string in the fifth aspect, first, the adhesive is applied to the designated positions on the back surface of the cell 100, then the back surface of the cell is connected to the welding strips, and the adhesive is applied to the designated positions on the front surface of the cell 100, after that the welding strips are connected to the front surface of the cell. With such cycle in turn, first the adhesive is applied to one surface of the cell 100, and the surface of the cell 100 to which the adhesive is applied is connected to the welding strips and then can be placed on a bearing platform, after that the adhesive is applied to the other surface of the cell. In this way, the operations are convenient, and the problem that it is inconvenient to apply the adhesive to the front and back surfaces of the cell 100 is solved.

Optionally, the adhesive used in the step of applying the adhesive is conductive adhesive. The conductive adhesive itself has a conductive function and can lead out current of the cell 100. Optionally, the adhesive used in the step of applying the adhesive also may be non-conductive adhesive. Exemplarily, when the non-conductive adhesive is used, the designated positions are not on the fine grid lines but between two adjacent fine grid lines. With such configuration, after the welding strips are connected to the cell 100, it is easier for the welding strips to contact the fine grid lines on the cell 100, thus, the welding strips and the fine grid lines on the cell 100 can enable good electrical contact.

Exemplarily, the designated positions are in a central line region between two adjacent fine grid lines. It should be noted that, two adjacent fine grid lines are arranged in parallel, so that the central line and the fine grid lines are also arranged in parallel, and a middle point of a perpendicular line connecting two adjacent fine grid lines is located on the central line. The central line region refers to a region that is widened by a preset distance in a direction close to two fine grid lines based on the central line, and optionally, the preset distance ranges from 1/6 to 2/3 of a distance between two adjacent fine grid lines. In the above, the preset distance also refers to a width of a central line region. If the designated positions are located in the central line region between two adjacent fine grid lines, when bonding the welding strips and the colloids 400, the colloids 400 will not easy to overflow onto the fine grid lines to affect the electrical contact between the welding strips and the fine grid lines.

Exemplarily, the adhesive used in the step of applying the adhesive includes at least one of hot-melt adhesive and photosensitive adhesive.

In some embodiments, a step of curing the colloids 400 is further included between step S54 and step S55.

After the colloids 400 are cured, the connection stability between the welding strips and the cell 100 can be increased. In the above, the manner of curing the colloids 400 includes heating, lighting or hot-pressing, for example, when the hot-melt adhesive is used as the colloids 400, the hot-melt adhesive can be cured by heating or hot-pressing; and when the photosensitive adhesive is used as the colloids 400, the photosensitive adhesive can be cured by providing lighting.

Exemplarily, heating manners include at least one of infrared heating, thermal conduction, induction heating, and hot air heating. Optionally, a heating temperature ranges from 100°C to 250 °C, for example, any one of 100 °C, 120 °C, 150 °C, 180 °C, 200 °C, 220 °C, and 250 °C or a range between any two thereof.

The connection method for a solar cell string in the fifth aspect is described by taking two cells 100 as an example, which includes steps of: aa) arranging a first welding strip 210; bb) providing a first cell, and applying adhesive to designated positions on a back surface of the first cell; cc) arranging the first cell on a first segment of the first welding strip 210, so that the back surface of the first cell is connected to the first segment of the first welding strip 210; dd) applying adhesive to designated positions on a front surface of the first cell; ee) arranging a second segment of a second welding strip 220 on the front surface of the first cell, so that the second segment of the second welding strip 220 is connected to the front surface of the first cell; ff) providing a second cell, and applying adhesive to designated positions on a back surface of the second cell; and gg) arranging the second cell on a first segment of the second welding strip 220, so that the back surface of the second cell is connected to the first segment of the second welding strip 220, thus obtaining the cell string.

Next, the connection method for a solar cell string in the fifth aspect is described by taking three cells 100 as an example, which includes the following steps: step aa)~gg) (the description is omitted herein); hh) applying adhesive to designated positions on a front surface of the second cell; and ii) arranging a second segment of a third welding strip on the front surface of the second cell, so that the second segment of the third welding strip is connected to the front surface of the second cell, thus obtaining the cell string.

In the connection method for a solar cell string in the fifth aspect, first, the adhesive is applied to the designated positions on the back surface of the cell, then the back surface of the cell is connected to the welding strips, and the adhesive is applied to the designated positions on the front surface of the cell, after that the welding strips are connected to the front surface of the cell. With such cycle in turn, first the adhesive is applied to one surface of the cell, and the surface of the cell to which the adhesive is applied is connected to the welding strips and then can be placed on a bearing platform, after that the adhesive is applied to the other surface of the cell, in this way, the operations can be facilitated.

In a sixth aspect, a manufacturing method for a solar cell module is provided, including the connection method for a solar cell string in the third aspect, the fourth aspect or the fifth aspect, and heating and laminating the obtained cell strings.

As any two adjacent cells in the solar cell string are connected together through the welding strips, and the fine grid lines on the cells form good electrical contact with the welding strips, after the obtained solar cell strings are laminated and heated, the electrical contact and the connection stability between the fine grid lines and the welding strips of the cells can be further improved, which facilitates leading out the current of the cell strings, and thus improves the structural stability of the solar cell module.

Exemplarily, after the heating and laminating, the welding strips form tight contact or alloy connection with the fine grid lines on the cells. As the welding strips form tight contact or alloy connection with the fine grid lines, the connection between the cells and the welding strips is more stable, and the welding strips form good electrical contact with the cells. It should be noted that, the tight contact refers to that the fine grid lines on the cells are in contact with the welding strips, and the fine grid lines are in tight contact with the welding strips through the laminating process, but the surfaces of the welding strips and the metal of the fine grid lines are not melted to form an alloy.

Optionally, each welding strip includes a copper substrate and a film layer on a surface of the copper substrate, and the film layer includes a metal layer or an alloy layer with a melting temperature of 120 to 160 °C. The film layer on the surface of the welding strip in the embodiments of the present disclosure contains a metal layer or an alloy layer with a melting temperature ranging from 120°C to 160 °C, therefore, the metal layer or the alloy layer can be melted by a relatively low temperature, and form a good alloy connection with the cells in the processes of laminating and heating. As a relatively low temperature is easier to reach in the operations, it is more convenient for process operations. Exemplarily, the film layer is a Sn alloy layer, for example, Sn alloy in the Sn alloy layer includes SnBiAg.

Exemplarily, the melting temperature of the metal layer or the alloy layer is any one of 120 °C, 130 °C, 140 °C, 150 °C, and 160 °C or a range between any two thereof.

Optionally, a temperature of heating and laminating ranges from 130 °C to 170 °C. The lower the temperature of heating and laminating is, the easier it is to achieve during the process operations. Optionally, the temperature of heating and laminating is any one of 130 °C, 140 °C, 150 °C, 160 °C, and 170 °C or a range between any two thereof.

In some embodiments, after obtaining the cell strings and prior to the heating and laminating, steps such as performing typesetting, welding bus bars, and EL test on the cell strings are further included.

The manufacturing method for a solar cell module in the sixth aspect includes performing typesetting, welding bus bars, and then heating and laminating on the cell strings obtained by the connection method for a solar cell string in the third aspect, the fourth aspect or the fifth aspect,

In a seventh aspect, a solar cell module is provided, which is manufactured by the above manufacturing method for a solar cell module.

The above-mentioned are merely for specific embodiments of the present disclosure and not used to limit the present disclosure, and for one skilled in the art, various modifications and changes may be made to the present disclosure. Any modifications, equivalent substitutions, improvements and so on, within the spirit and principle of the present disclosure, should be covered within the scope of protection of the present disclosure.

In the present specification, it is described that the colloids are formed by applying the adhesive, wherein the meaning of applying the adhesive includes actions of performing dispensing, spraying, printing etc. on the adhesive to form the colloids.

### Industrial Applicability

The present disclosure is applied to the packaging method for a solar cell module, the connection method for a solar cell string, and the solar cell module and the preparation method therefor. Since the cells do not need to be printed with the main grid lines, the welding strips are directly fixed on the cells and the electrical connection between the welding strips and the fine grid lines is ensured, so that not only the conductive function of the solar cell module is achieved, but also the consumption of silver paste can be greatly reduced, further reducing the costs of the cell module.

## Claims

1. A packaging method for a solar cell module, **characterized in that** it comprises:
a step of acquiring cells: acquiring cells which are printed with fine grid lines and without a main grid line or only contains fine main grid lines;
a step of connecting the cells: connecting any two of the cells through welding strips so as to obtain a plurality of cell strings, wherein the step of connecting any two of the cells through welding strips comprises fixing the welding strips on the cells through colloids, and making the welding strips in direct contact with the fine grid lines on corresponding cells; and each cell string comprises a plurality of cells;
a step of packaging the cell strings: performing typesetting and welding bus bars on the plurality of cell strings so as to obtain a cell string laminate; and
a step of packaging the cell string laminate: heating and laminating the cell string laminate, so that each welding strip forms an alloy connection with the fine grid lines on a surface of a corresponding cell, so as to complete the packaging of the solar cell module.

2. The packaging method for a solar cell module according to claim 1, **characterized in that** the step of connecting the cells further comprises:
a step of applying adhesive: applying adhesive to the surface of each cell to form the colloids, wherein there are a plurality of colloids distributed on the surfaces of the cells;
a wiring step: arranging a plurality of welding strips at equal intervals in an extending direction perpendicular to the fine grid lines on the surface of each cell, wherein each welding strip is perpendicular to each fine grid line on the surface of the corresponding cell; and
a fixing step: applying a preset pressure to each welding strip on each cell, so that each welding strip is bonded to the corresponding cell through corresponding colloids, and each welding strip is in direct contact with each fine grid line on the surface of the corresponding cell.

3. The packaging method for a solar cell module according to claim 2, **characterized in that** the packaging method further comprises, before the fixing step, a pre-welding step: pre-welding each welding strip on each cell, so that each welding strip is fixed on the surface of the corresponding cell, and each welding strip is in direct contact with the fine grid lines on the surface of the corresponding cell, wherein a manner of the pre-welding is any one of infrared heating, heat conduction, induction heating, and heat sealing heating.

4. The packaging method for a solar cell module according to claim 2, **characterized in that** the step of applying adhesive comprises applying the adhesive with a glue dispenser to the surface of each cell to form a plurality of colloids.

5. The packaging method for a solar cell module according to claim 4, **characterized in that** a distribution position of each colloid does not coincide with contact positions of the welding strips and the fine grid lines.

6. The packaging method for a solar cell module according to any one of claims 1 to 5, **characterized in that** the colloids are non-conductive adhesive.

7. The packaging method for a solar cell module according to any one of claims 1 to 6, **characterized in that** each welding strip is fixed on the corresponding cell through at least two colloids.

8. The packaging method for a solar cell module according to any one of claims 1 to 7, **characterized in that** each welding strips is a copper welding strip with a coating; and the coating is a metal layer or an alloy layer, and wherein a melting point temperature of the metal layer and the alloy layer is 120 °C~160 °C.

9. The packaging method for a solar cell module according to claim 8, **characterized in that** the coating is a tin layer or a tin bismuth silver alloy layer.

10. The packaging method for a solar cell module according to claim 8, **characterized in that** a temperature of heating and laminating in the step of packaging the cell string laminate is 130 °C∼170 °C.

11. The packaging method for a solar cell module according to any one of claims 1 to 10, **characterized in that** the step of packaging the cell string laminate further comprises: before heating and laminating the cell string laminate, limiting each welding strip by a pre-crosslinked packaging film.

12. The packaging method for a solar cell module according to claim 11, **characterized in that** the pre-crosslinked packaging film is made of any one of packing material of EVA, POE, and PVB.

13. The packaging method for a solar cell module according to any one of claims 1 to 12, **characterized in that** the welding strips have a diameter ranging from 0.1 mm to 0.3 mm.

14. The packaging method for a solar cell module according to any one of claims 1 to 13, **characterized in that** the cells are any one of heterojunction cells, tunnel oxide passivated contact cells, and passivated emitter and rear cells.

15. The packaging method for a solar cell module according to any one of claims 1 to 14, **characterized in that** a number of fine grid lines on a front surface and a back surface of each cell ranges from 15 to 35.

16. A solar cell module, **characterized in that** it is manufactured by the packaging method for a solar cell module according to any one of claims 1-15.

17. A solar cell module, **characterized in that** it comprises a plurality of cell strings, wherein each cell string comprises:
a plurality of cells, each being printed with fine grid lines and without a main grid; and
a plurality of welding strips, connecting two adjacent cells to form the cell string, **characterized in that** the welding strips are fixed on corresponding cells through colloids, and the welding strips are in direct contact with the fine grid lines on the corresponding cells, and
wherein the plurality of cell strings form a cell module by typesetting and welding bus bars, and
each welding strip forms an alloy connection with the fine grid lines on a surface of the corresponding cell through heating and laminating.

18. The solar cell module according to claim 17, **characterized in that**
the welding strips are arranged at equal intervals in an extending direction perpendicular to the fine grid lines on the surface of the corresponding cell, and each of the welding strips is perpendicular to each fine grid line on the surface of the corresponding cell; and
each of the welding strips is bonded to the corresponding cell through the colloids formed on the surface of the corresponding cell, and each of the welding strips is in direct contact with each fine grid line on the surface of the corresponding cell.

19. A connection method for a solar cell string, **characterized in that** it comprises:
S31, providing a cell;
S32, arranging welding strips on a front surface and a back surface of the cell;
S33, applying adhesive to designated positions on the front surface and the back surface of the cell to form colloids, and connecting the cell and the welding strips through the colloids; and
S34, repeating step S31 to step S33 to complete connection of a preset number of cells, so as to obtain the solar cell string.

20. The connection method for a solar cell string according to claim 19, **characterized in that** the connection method further comprises, after step S22 and before step S33, a step of forming a preliminary connection between the welding strips and the fine grid lines on the cell by heating.

21. The connection method for a solar cell string according to claim 19 or 20, **characterized in that** the connection method further comprises, after step S33 and before step S34, a step of curing the colloids.

22. The connection method for a solar cell string according to any one of claims 19-21, **characterized in that** the adhesive used for the colloids is a conductive adhesive or a non-conductive adhesive.

23. The connection method for a solar cell string according to any one of claims 19-22, **characterized in that** the front surface and the back surface of the cell have no main grid line or contain fine main grid lines.

24. The connection method for a solar cell string according to any one of claims 19-23, **characterized in that** the designated positions on the cell are determined by marks screen-printed on the cell.

25. The connection method for a solar cell string according to any one of claims 19-24, **characterized in that** when arranging the welding strips on the front surface and the back surface of the cell, the plurality of welding strips are arranged perpendicular to the fine grid lines on the cell.

26. A connection method for a solar cell string, **characterized in that** the cell string comprises a plurality of cells connected in series, two adjacent ones of the cells are connected through welding strips, and each of the welding strips comprises a first segment and a second segment, and wherein the connection method comprises:
S41, arranging a first welding strip, and applying adhesive to an upper surface of the first segment of the first welding strip to form colloids;
S42, arranging a cell on the first segment of the first welding strip, so that a back surface of the cell is connected to the first segment of the first welding strip;
S43, applying the adhesive to preset positions on a front surface of the cell to form the colloids;
S44, arranging the second segment of a second welding strip on the front surface of the cell, so that the second segment of the second welding strip is connected to the front surface of the cell; and
S45: repeating steps S41-S44 to complete connection of a preset number of cells, so as to form the cell string.

27. The connection method for a solar cell string according to claim 26, **characterized in that** the front surface and the back surface of each of the cells have no main grid line or contain a fine main grid.

28. The connection method for a solar cell string according to claim 26 or 27, **characterized in that** the adhesive used for the colloids is a conductive adhesive or a non-conductive adhesive.

29. The connection method for a solar cell string according to claim 28, **characterized in that** the adhesive used for the colloids is the non-conductive adhesive, and the preset positions are not on the fine grid lines.

30. The connection method for a solar cell string according to any one of claims 26-29, **characterized in that** the upper surface of the first segment of the first welding strip is a flat surface.

31. The connection method for a solar cell string according to claim 20, **characterized in that** the upper surface of the first segment of the first welding strip has a width of 0.2-1.2 mm.

32. The connection method for a solar cell string according to any one of claims 26~32, **characterized in that** between step S44 and step S45, a step of curing the colloids is further comprised.

33. The connection method for a solar cell string according to any one of claims 26~32, **characterized in that** each of the welding strips comprises a copper substrate and a film layer on an entire surface of the copper substrate, and the film layer comprises a metal layer or an alloy layer having a melting temperature of 120~160 °C.

34. A connection method for a solar cell string, **characterized in that** the cell string comprises a plurality of cells connected in series, two adjacent ones of the cells are connected together through welding strips, each of the welding strips comprises a first segment and a second segment, and the connection method comprises:
S51, providing a cell, and applying adhesive to designated positions on a back surface of the cell to form colloids;
S52, arranging the cell on the first segment of an arranged first welding strip, so that the back surface of the cell is connected to the first segment of the first welding strip;
S53, applying the adhesive to designated positions on a front surface of the cell to form the colloids;
S54, arranging the second segment of a second welding strip on the front surface of the cell, so that the second segment of the second welding strip is connected to the front surface of the cell; and
S55, repeating steps S51 to S54 to complete connection of a preset number of cells, so as to obtain the cell string.

35. The connection method for a solar cell string according to claim 34, **characterized in that** the connection method further comprises, between step S54 and step S55, a step of curing the colloids.

36. The connection method for a solar cell string according to claim 34 or 35, **characterized in that** the front surface and the back surface of each of the cells have no main grid line or contain fine main grid lines.

37. The connection method for a solar cell string according to any one of claims 34-36, **characterized in that** the designated positions on the cell are determined by marks screen-printed on the cell.

38. The connection method for a solar cell string according to any one of claims 34-37, **characterized in that** the adhesive used for the colloids is a conductive adhesive or a non-conductive adhesive.

39. The connection method for a solar cell string according to claim 38, **characterized in that** the adhesive used for the colloids is the non-conductive adhesive, and the designated positions are not on the fine grid lines.

40. The connection method for a solar cell string according to any one of claims 34-39, **characterized in that** each of the welding strips comprises a copper body and a coating layer on an entire surface of the copper body, **characterized in that** the coating layer comprises a metal layer or an alloy layer with a melting temperature of 120~160 °C.

41. A manufacturing method for a solar cell module, **characterized in that** it comprises the connection method for a solar cell string according to any one of claims 19~40, and a step of heating and laminating the formed cell strings.

42. The manufacturing method for a solar cell module according to claim 41, **characterized in that** after the step of heating and laminating, the welding strips form an alloy connection or a close contact with the fine grid lines on the cells.

43. A solar cell module, **characterized in that** it is manufactured by the manufacturing method for a solar cell module according to claim 41 or 42.
